# EUROPEAN PATENT SPECIFICATION

(11) **EP 3 569 733 B1**
(45) Date of publication and mention of the grant of the patent: **14.04.2021**
(21) Application number: 17892817.2
(22) Date of filing: 25.04.2017
(51) Int. Cl.: C23C 16/513, C23C 16/517, C23C 16/448, C09D 4/02, C09D 4/00, B05D 1/00, C23C 16/511, C23C 16/515, H05K 3/28, H05K 1/00, B05D 5/08

(54) **METHOD FOR PREPARING WATERPROOF AND ELECTRIC BREAKDOWN-RESISTANT COATING**
VERFAHREN ZUR HERSTELLUNG EINER WASSERFESTEN UND ELEKTRISCHEN DURCHSCHLAGFESTEN BESCHICHTUNG
PROCÉDÉ DE PRÉPARATION D'UN REVÊTEMENT ÉTANCHE À L'EAU ET RÉSISTANT AU CLAQUAGE ÉLECTRIQUE

(30) Priority: 23.01.2017 CN 201710049269
(43) Date of publication of application: 20.11.2019
(73) Proprietor: Jiangsu Favored Nanotechnology Co., Ltd, Wuxi, Jiangsu 214183 (CN)
(72) Inventor: ZONG, Jian, Wuxi Jiangsu 214183 (CN)
(74) Representative: Berkkam, Ayfer
(86) International application number: PCT/CN2017/081792
(87) International publication number: WO 2018/133237

(56) References cited:
- WO-A1-00/14323
- WO-A1-2013/011315
- WO-A2-2008/146024
- CN-A- 1 322 264
- CN-A- 1 539 896
- CN-A- 104 718 258
- TSUJI O ET AL: "Stabilization of chlorofluorocarbons (CFCs) by plasma copolymerization with hydrocarbon monomers", THIN SOLID FILMS, ELSEVIER, AMSTERDAM, NL, vol. 390, no. 1-2, 30 June 2001 (2001-06-30), pages 159-164, XP004246668, ISSN: 0040-6090, DOI: 10.1016/S0040-6090(01)00929-4

## Description

### Technical Field

The present invention belongs to the technical field of plasma chemical vapor deposition, and particularly relates to a preparation method of electric breakdown-resistant coating.

### Background

Moisture is the most common and most destructive key factor of printed circuit boards (PCB). Excessive moisture may substantially reduce the insulation resistivity between conductors, accelerate high-speed decomposition, reduce Q values and corrode conductors. If used in splashing, spilling, soaking or underwater environment, electronic and electrical devices are more apt to generate short circuit and corrosion short circuit and then fail.

Because of the characteristics of economy, easy painting, wide application range and the like, polymer coating is frequently used for protection of material surface, which can endow the material with good physical and chemical durability. Based on the barrier property of the polymer coating, the protective film thereof formed on the surface of the electronic and electrical devices and the circuit boards can effectively isolate the circuit boards and also can protect circuits from erosion and destroy in water environment, thereby improving the reliability of the circuit boards, increasing the safety factors thereof, and guaranteeing the service life thereof, thus being used as a waterproof coating.

Conformal coating is a process of coating a specific material on a PCB to form an insulating protective layer which is consistent with the coated object in appearance, and is a frequently-used waterproof method for circuit boards, which can effectively isolate circuit boards, and also can protect circuits from erosion and destroy of severe environment. The problem that solvent is apt to cause damage to the circuit board device in the liquid phase method also exists in the process of conformal coating preparation; thermal curing coating is apt to cause damage to the device at high temperature; and it is difficult for the photocurable coating to be coated inside a closed device. American Union Carbide Co. has developed and applied a novel conformal coating material, i.e. Parylene coating (patent), which is a p-xylene polymer, has low water and gas permeability and high barrier effect , and can achieve the functions of moisture resistance, water resistance, rust resistance and acid-alkali corrosion resistance. It is found through research that poly-p-xylene is generated by deposition in a vacuum state, and can be applied to the field to which liquid paint dare not relate, for example, protection of high-frequency circuit and extremely weak current system. The thickness of the polymer film coating is the main reason causing the failure of conformal protection of poly-p-xylene vapor deposition. The thickness of 3-7 micrometers of printed circuit board polymer film coating is apt to cause local corrosion failure. In the case where high-frequency dielectric loss is not affected, the thickness of the coating shall be equal or greater than 30 micrometers. Because of the disadvantages of high cost of preparation material, strict preparation condition of coating (high temperature and high vacuum degree), and low film-forming rate, it is difficult for Parylene coating to be widely applied. In addition, thick coating is apt to cause the problems such as poor heat dissipation, signal blocking, increase of coating deficiencies and the like.

Plasma chemical vapor deposition (PCVD) is a technology to generate a solid film by activating reactive gas by plasma and promoting chemical reaction on the matrix surface or near surface space. The plasma chemical vapor deposition method has the following advantages:
(1) it is a dry process, and the generated film is even without pinhole;
(2) the chemical and physical properties such as solvent resistance, chemical corrosion resistance, heat resistance and abrasion resistance of plasma polymer film are stable;
(3) plasma polymer film has good adhesion to base material;
(4) a uniform film can also be made on the irregular concave-convex surface of the base material;
(5) the coating preparation temperature is low, and coating preparation can be carried out at room temperature, which effectively avoids the damage to temperature sensitive devices; and
(6) the plasma technology can not only be used for preparing coating with a micron-scale thickness, but also can be used for preparing ultra-thin coating with a nano-scale thickness.

Relevant prior art may include WO 0014323, which relates to textile articles and clothing such as outdoor garments, indoor garments exposed to aqueous liquid, swim wear, leather, hats, textile sun roofs for cars, sun blinds or awnings which have at least part of their surface provided with super hydrophobicity.

WO 2013011315 discloses a method of forming a liquid repellent coating on a surface of a substrate, where the surface is exposed to a monomer in a plasma deposition process under conditions that maintain the monomer in situ for a period of time to allow a polymeric layer to form on the surface, wherein the conditions comprise at least one cycle of varying pressure.

WO 2008146024 discloses method of forming a liquid repellent coating on a surface of a substrate, where the surface is exposed to a monomer in a plasma deposition process under conditions that maintain the monomer in situ for a period of time to allow a polymeric layer to form on the surface, wherein the conditions comprise at least one cycle of varying pressure.

A publication by Tsuji, O et al., titled, Stabilization of Chlorofluorocarbons (CFCs) by Plasma Copolymerization with Hydrocarbon Monomers, describes an experiment carried out relating to the plasma copolymerization of CFCs (trichlorofluorocarbon) and PFC (perfluorocarbon) with C2 hydrocarbons. For the purposes of improving the recovery rate of the copolymerization process, the author developed a cascade-type plasma reaction system. The reaction system was equipped with a maximum of 12 reaction tubes, each with an internal diameter of 32 mm and 390 mm in length. In the copolymerization experiments using the cascade type plasma reaction system, the CFC recovery rate reached a level of 95%, which boasts a vast improvement of the 30-40% recovery rate previously achieved with parallel plate and tubular reaction systems. The author claims that when performing plasma copolymerization of hydrocarbons and CFCs, which contain chlorine and fluorine, the results varied, depending on the dwell time in the reactor. The level of importance of the parameters that influence the recovery rate could be ranked as follows: CFC/hydrocarbon mixing ratio>RF power>reactor pressure. When the CFC/hydrocarbon mole ratio is CFC-113: C2H4=1:1, the recovery rate reaches the maximum level where 95% of the CFCs are recovered in the form of copolymers and related substances.

### Summary

To solve the above-mentioned technical problems, the present invention provides a preparation method of a waterproof and electric breakdown-resistant coating according to claim 1. The present invention introduces additional cross-linking patches to form a cross-linking structure by introducing other monomer components with polyfunctional group cross-linking structure. When plasma undergoes glow discharge, an active group with relatively high energy in the monomer components is broken to form active patches, and additional active patches being introduced are cross-linked in the plasma environment to form a network structure.

The present invention adopts the following technical solution:
1. A preparation method of a waterproof and electric breakdown-resistant coating, characterized by comprising the following steps:
   (1) placing a base material in a reaction chamber of a plasma chamber, vacuuming the reaction chamber continuously to a vacuum degree of 10-200 millitorrs, and feeding inert gas or nitrogen;
   (2) feeding monomer vapour until the vacuum degree is 30-300 millitorrs, starting plasma discharge to conduct chemical vapor deposition, and preparing a waterproof and electric breakdown-resistant coating on the surface of the base material,
      wherein the component of the monomer vapour is:
      a mixture of at least one monofunctional unsaturated fluorocarbon resin and at least one polyfunctional unsaturated hydrocarbon derivative, and the mass percent of the polyfunctional unsaturated hydrocarbon derivative in the monomer vapour is 30-50%;
   (3) stopping plasma discharge, stopping feeding the monomer vapour, vacuuming continuously to maintain a vacuum degree of 10-200 millitorrs in the reaction chamber, feeding air after 1-5 min to make the reaction chamber reach atmospheric pressure, and then taking out the base material.

The base material in the step (1) is a solid material, and the solid material is an electronic component or an electrical component;
and either interface thereof after the waterproof and electric breakdown-resistant coating is prepared on the surface of the base material may be exposed to the environment of the international industrial waterproof grade standards IPX1-IPX8.

The environment of the international industrial waterproof grade standards IPX1-IPX8 is as follows:
Grade IPX1: eliminating harmful effect of vertically falling water drops;
Grave IPX2: having a protecting effect on water drops falling within an angle of 15 degrees made with the vertical direction;
Grade IPX3: eliminating harmful effect of vaporous water drops at an angle of 60 degrees made with the vertical direction;
Grade IPX4: eliminating harmful effect of water drops splashing in various directions;
Grade IPX5: eliminating harmful effect on water jets sprayed by spray nozzles in various directions;
Grade IPX6: eliminating harmful effect on water jets powerfully sprayed by spray nozzles in various directions;
Grade IPX7: requiring that the distance from the top to the water surface is 0.15-1 meter, the performance is not affected if it is continuously placed in water for 30 minutes, and no water enters;
Grade IPX8: requiring that the distance from the top to the water surface is 1.5-30 meters, the performance is not affected if it is continuously placed in water for 30 minutes, and no water enters.

The plasma chamber in the step (1) has a volume of 50-1000 liters, and the temperature of the plasma chamber is controlled at 30-60°C; the discharge of the plasma at this temperature is beneficial to monomer polymerization; the flow of the inert gas or nitrogen being fed is 5-300 sccm, and the inert gas is argon or helium or the mixture of both. The aim of feeding the inert gas or nitrogen is to obtain a stable plasma environment.

In the step (2):
the monomer vapour is fed to atomize and volatilize the monomer through a charging pump and introduce the monomer into the reaction chamber at a low pressure of 10-200 millitorrs, wherein the flow of the monomer vapour fed is 10-1000 µL/min;
the monomer is a mixture of at least one monofunctional unsaturated fluorocarbon resin and at least one polyfunctional unsaturated hydrocarbon derivative, and the mass percent of the polyfunctional unsaturated hydrocarbon derivative in the monomer vapour is 30-50%;
the monofunctional unsaturated fluorocarbon resin includes:
   3-(perfluoro-5-methylhexyl)-2-hydroxypropyl methacrylate, 2-(perfluorodecyl)ethyl methacrylate, 2-(perfluorohexyl)ethyl methacrylate, 1,1,2,2-Tetrahydroperfluorotetradecyl acrylate, 1H,1H,2H,2H-Heptadecafluorodecyl acrylate, 1H,1H,2H,2H-Perfluorooctylacrylate, 2-(Perfluorobutyl)ethyl acrylate, (2H-perfluoropropyl)-2-acrylate, (perfluorocyclohexyl)methyl acrylate, 1-propyne,3,3,3-trifluoro-, 1-ethynyl-3,5-difluorobenzene or 4-ethynyl-trifluorotoluene; and
   the monofunctional unsaturated fluorocarbon resin has the following advantages: fluorocarbon resin has a skeleton formed by firm C-F bonds, has better heat resistance, chemical resistance, cold resistance, low temperature flexibility, weather resistance and electrical properties as compared with other resins, and in addition, also has non-adhesive property and non-wetting property. Therefore, fluorocarbon resin coating is especially suitable for the protection of material surface, which can not only endow the material with good physical and chemical durability, but also endow the material with excellent waterproof and oil-proof function, and can be widely applied to painting fields of separation, optics, medicine, electronics, precise apparatuses, high-grade clothes, etc. The polyfunctional unsaturated hydrocarbon derivative includes:
   ethoxylated trimethylolpropane triacrylate, tripropylene glycol diacrylate, divinylbenzene, poly(ethylene glycol) diacrylate, 1,6-hexanediol diacrylate, ethylene glycol diacrylate, diethylene glycol divinyl ether or neopentyl glycol diacrylate. The polyfunctional unsaturated hydrocarbon derivative has multiple cross-linking patches, which can enhance protection performance of a coating network after being added.

In step (2), before feeding the first monomer vapour, the base material is pre-processed by bombardment with glow discharge, wherein the power of glow discharge is 2-500 W, and the discharge duration is 300-600 s. The pre-processing by bombardment can clean impurities on the surface of the base material, and can activate the surface of the base material at the same time, thereby being beneficial to the deposition of the coating and improving the binding force of the coating and the base material.

In the step (2), the power of plasma discharge is 2-500 W, the continuous discharge duration is 300-7200 s, and the plasma discharge is in the manner of radio frequency discharge, microwave discharge, medium frequency discharge or spark discharge. Radio frequency plasma is generated by ionizing air around the electrode using high frequency and high voltage. Microwave method is a method for exciting plasma using the energy of microwave, has the advantage of high energy utilization efficiency, and meanwhile, is an excellent method for high-quality, high-rate and large-area preparation because plasma is pure due to electrodeless discharge.

The energy output mode controlling the plasma radio frequency during plasma radio frequency discharge is pulse or continuous; when the energy output mode of the plasma radio frequency is pulse, the pulse duration is 2µs-1ms, and the repetition frequency is 20Hz-10kHz. During continuous plasma radio frequency discharge deposition, plasma has a certain etching effect on the deposited film, and pulse radio frequency discharge gives certain deposition time relative to continuous radio frequency discharge, thereby being beneficial to making coating thick and dense.

Compared with the prior art, the technical solution of the present invention has the following advantages:
1. The introduction of the polyfunctional group cross-linking structure makes the coating have a dense network structure, so that the time of resisting underwater electrification and electric breakdown resistance of the coating film are increased while guaranteeing hydrophobicity.
   Monofunctional monomers are used for plasma polymerization in general, and a coating with a certain cross-linking structure is obtained. The cross-linking structure is formed due to that the monomers are randomly broken during plasma glow discharge and form numerous active patches which are cross-linked. However, such cross-linking structure is loose, contains more linear components, and has inadequate solution permeation resistance and dissolving capacity. The present invention introduces additional cross-linking patches to form a cross-linking structure by introducing other monomer components with polyfunctional group cross-linking structure. When plasma undergoes glow discharge, an active group with relatively high energy in the monomer components is broken to form active patches; and additional active patches being introduced are cross-linked in the plasma environment to form a network structure.
   Compared with the coating structure with linear components, the network structure has more excellent density, and can effectively increase the time of resisting underwater electrification and electric breakdown resistance of the film. The surface of the coating base material is activated to obtain numerous active patches in plasma environment, and these active patches are combined with the active free radicals of the monomer material excited by plasma through strong chemical bonds to produce elementary reaction of various forms and types, so the nanometer film of the base material has superior binding force and mechanical strength. By controlling different monomer cooperation manners and regulating different process conditions to effectively regulate the hydrophobicity, water repellency and long-time underwater electrification resistance, a dense film with a special microstructure is obtained, and time of resisting underwater electrification and electric breakdown resistance are respectively improved by 30-55%.
2. By introducing other monomers with crosslinking structure, and controlling monomer proportion and process parameters to obtain a polymer nanometer coating with composite and gradual-change structure, the hydrophobicity of a film is guaranteed, and corrosion resistance and underwater electrification resistance of electronic products are improved.

Electronic devices used in daily life are easily damaged by liquid erosion, and are easily exposed to liquid environment while in use, for example, falling into and splashing into liquid, so that electronic parts and components are easily short-circuited, and then irreparable damages are caused to the electronic devices. The coating method of the patent for invention has the advantages that the service life of the nanometer coating in solvent and corrosive environment is greatly increased, and the preventing effect of the product is improved, and is mainly applied to the following products:
1. Portable keyboard for devices: portable keyboard has the characteristic of small in size and light in weight; is frequently used for devices such as computer, cellphone and the like; and can facilitate a user in handling official business in journey. However, when encountering common liquid pollution, for example, unexpected turnover of a cup filling with water, soakage of rainwater or perspiration, the keyboard is easily short-circuited internally and then is damaged. After coating same using this nanometer coating, the keyboard can adapt to more serious environment if it is guaranteed that the surface of the keyboard is easy to clean and the function of the keyboard is good after encountering water.
2. LED screen: LED screen has the functions of demonstration, storefront decoration, lighting, warning and the like. For some functions thereof, there is a need to encounter severe environments such as rainwater or heavy dust, for example, on rainy days, for outdoor LED advertising screens of the Mall, road warning lights, LED screen control panels of production shops, these severe environments cause LED screens to fail, and moreover, to accumulate dust easily and not to be cleaned easily. After the nanometer coating is used, the above-mentioned problems can be effectively solved.
3. Smart fingerprint lock: fingerprint lock is a smart lock, is integrated with computer information technology, electronic technology, mechanical technology and modern hardware technology, and is widely used in the field of police criminal detection and judicature. After encountering water, the internal circuit of the fingerprint lock is easily short-circuited and is difficult to repair, and there is a need to detach the fingerprint lock by violence. After the coating is used, this problem can be avoided.
4. Hearing-aid and Bluetooth earphone: neither the hearing-aid nor the Bluetooth earphone is provided with a communication line, after the coating is used, a user can use the hearing-aid and the Bluetooth earphone in watery environment within certain time, for example, bathing, rainy day, the devices may not be damaged due to rainwater soaking.
5. Some sensors: some sensors need operate in liquid environment, such as water pressure and oil pressure sensors, sensors used in underwater operation devices and sensors often encountering water in working environment, after these sensor use the coating, it can be guaranteed that the sensors may not fail due to that liquid invades the internal structure of the mechanical devices.
6. Most 3C products: such as mobile phone, laptop, PSP and the like.
7. Other devices requiring water resistance: including devices required to operate in humid environment or devices of which the normal operation of the internal weak current circuits may be affected when encountering unforeseen circumstances such as liquid spill and the like.

### Detailed Description

The present invention is described below in detail in combination with specific embodiments. However, the present invention is not limited to these embodiments.

### Embodiment 1

1. A preparation method of a waterproof and electric breakdown-resistant coating, characterized by comprising the following steps:
   (1) placing a base material in a reaction chamber of a plasma chamber, vacuuming the reaction chamber continuously to a vacuum degree of 10 millitorrs, and feeding inert gas,
      wherein the base material in the step (1) is a solid material, and the solid material is an electronic component, i.e. a circuit board;
      and any interface thereof after the waterproof and electric breakdown-resistant coating is prepared on the surface of the base material may be exposed to the environment of the international industrial waterproof grade standard IPX1;
      the plasma chamber in the step (1) has a volume of 50 liters, and the temperature of the plasma chamber is controlled at 30°C; the flow of the inert gas being fed is 5 sccm, and the inert gas is argon;
   (2) feeding a monomer vapour until the vacuum degree is 30 millitorrs, starting plasma discharge to conduct chemical vapor deposition, and preparing a waterproof and electric breakdown-resistant coating on the surface of the base material,
      in the step (2):
      the monomer vapour is fed to atomize and volatilize the monomer through a charging pump and introduce the monomer to the reaction chamber at a low pressure of 10 millitorrs, wherein the flow of the monomer vapour fed is 10 µL/min;
      the component of the monomer vapour is:
         a mixture of one monofunctional unsaturated fluorocarbon resin and one polyfunctional unsaturated hydrocarbon derivative, and the mass percent of the polyfunctional unsaturated hydrocarbon derivatives in the monomer vapour is 30%;
         the monofunctional unsaturated fluorocarbon resin includes: 1H,1H,2H,2H-Heptadecafluorodecyl acrylate;
         the polyfunctional unsaturated hydrocarbon derivative includes: ethylene glycol diacrylate;
         in step (2), before feeding the first monomer vapour, the base material is pre-processed by bombardment with glow discharge;
         in step (2), the power of plasma discharge is 2 W, the continuous discharge duration is 7200 s, the plasma discharge is in the manner of radio frequency discharge, and the energy output mode of the plasma radio frequency is by pulse in the radio frequency discharge process of the plasma; when the energy output mode of the plasma radio frequency is by pulse, the pulse width is 2 mu s, and the repetition frequency is 20 kHz;
   (3) stopping plasma discharge, stopping feeding the monomer vapour, vacuuming continuously to maintain a vacuum degree of 10 millitorrs in the reaction chamber, feeding air after 1 min to make the reaction chamber reach atmospheric pressure, and then taking out the base material.

For underwater electrification resistance, results of underwater soaking test are as follows:
the following table shows a test for time taken when the current of the coating prepared in this embodiment at different voltages reaches 1mA:

| | | | |
|---|---|---|---|
| Voltage | 3.8v | 5v | 12.5v |
| Time | > 10min | 0min | 0min |

In IPX 1, under vertical water-drip test of 10min, electrical components operate normally.

### Embodiment 2

The process steps of this embodiment are almost the same as those of embodiment 1, and different process parameters are as follows:
1. In step (1), the reaction chamber is vacuumed to a vacuum degree of 40 millitorrs, and inert gas is fed;
the base material is a solid material which is an electrical component, i.e. a TV shell, and any interface thereof after the waterproof and electric breakdown-resistant coating is prepared on the surface of the base material may be exposed to the environment of the international industrial waterproof grade standard IPX 3.
The plasma chamber has a volume of 260 liters, and the temperature of the plasma chamber is controlled at 40°C; the flow of the inert gas being fed is 60 sccm, and the inert gas is helium.
2. In step (2), the monomer vapour is fed until the vacuum degree is 80 millitorrs; and plasma discharge is started;
the monomer vapour is fed to atomize and volatilize the monomer through a charging pump and introduce the monomer to the reaction chamber at a low pressure of 40 millitorrs, wherein the flow of the monomer vapour fed is 90 µL/min;
the component of the monomer vapour is:
a mixture of one monofunctional unsaturated fluorocarbon resin and two polyfunctional unsaturated hydrocarbon derivative, and the mass percent of the polyfunctional unsaturated hydrocarbon derivative in the monomer vapour is 35%;
the monofunctional unsaturated fluorocarbon resin includes: 2-(perfluorodecyl)ethyl methacrylate;
the polyfunctional unsaturated hydrocarbon derivative includes: tripropylene glycol diacrylate and divinylbenzene;
in step (2), the power of plasma discharge is 25 W, the continuous discharge duration is 5800 s, the plasma discharge is in the manner of radio frequency discharge, and the energy output mode of the plasma radio frequency is by pulse in the radio frequency discharge process of the plasma; when the energy output mode of the plasma radio frequency is by pulse, the pulse width is 0.1 ms, and the repetition frequency is 400 kHz.
For underwater electrification resistance, results of underwater soaking test are as follows:
The following table shows a test for time taken when the current of the coating prepared in this embodiment at different voltages reaches 1mA:

| | | | |
|---|---|---|---|
| Voltage | 3.8v | 5v | 12.5v |
| Time | 50min | 10min | 0min |

In IPX 3, under spray-head water pouring test of 10min, electrical components operate normally.
3. In step (3), a vacuum degree of 70 millitorrs is maintained in the reaction chamber, air is fed after 2 min to make the reaction chamber reach atmospheric pressure.

### Embodiment 3

The process steps of this embodiment are almost the same as those of embodiment 1, and different process parameters are as follows:
1. In step (1), the reaction chamber is vacuumed to a vacuum degree of 100 millitorrs, and inert gas is fed;
the base material is a solid material which is an electrical component, i.e. a cellphone, and any interface thereof after the waterproof and electric breakdown-resistant coating is prepared on the surface of the base material may be exposed to the environment of the international industrial waterproof grade standard IPX 4;
the plasma chamber has a volume of 380 liters, and the temperature of the plasma chamber is controlled at 45°C; the flow of the inert gas being fed is 130 sccm, and the inert gas is the mixture of helium and argon.
2. In step (2), the monomer vapour is fed until the vacuum degree is 130 millitorrs, and plasma discharge is started;
the monomer vapour is fed to atomize and volatilize the monomer through a charging pump and introduce the monomer to the reaction chamber at a low pressure of 100 millitorrs; and the flow of the monomer vapour fed is 180 µL/min;
the component of the monomer vapour is:
a mixture of two monofunctional unsaturated fluorocarbon resin and three polyfunctional unsaturated hydrocarbon derivative, and the mass percent of the polyfunctional unsaturated hydrocarbon derivative in the monomer vapour is 40%;
the monofunctional unsaturated fluorocarbon resin includes: (perfluorocyclohexyl)methyl acrylate and 1-ethynyl-3,5-difluorobenzene;
the polyfunctional unsaturated hydrocarbon derivative includes: ethoxylated trimethylolpropane triacrylate, divinylbenzene and 1,6-hexanediol diacrylate;
in step (2), the power of plasma discharge is 100 W, the continuous discharge duration is 4500 s, the plasma discharge is in the manner of radio frequency discharge, and the energy output mode of the plasma radio frequency is by pulse in the radio frequency discharge process of the plasma; when the energy output mode of the plasma radio frequency is by pulse, the pulse width is 1 ms, and the repetition frequency is 10 kHz.

3. In step (3), a vacuum degree of 130 millitorrs is maintained in the reaction chamber, air is fed after 3 min to make the reaction chamber reach atmospheric pressure.
For underwater electrification resistance, results of underwater soaking test are as follows:
The following table shows a test for time taken when the current of the coating prepared in this embodiment at different voltages reaches 1mA:

| | | | |
|---|---|---|---|
| Voltage | 3.8v | 5v | 12.5v |
| Time | >110min | 50min | 5min |

In IPX 4, under spray-head water-splash test of 10min, electrical components operate normally.

### Embodiment 4

The process steps of this embodiment are almost the same as those of embodiment 1, and different process parameters are as follows:
1. In step (1), the reaction chamber is vacuumed to a vacuum degree of 150 millitorrs, and nitrogen is fed;
the base material is a solid material which is an electrical component, and any interface thereof after the waterproof and electric breakdown-resistant coating is prepared on the surface of the base material may be exposed to the environment of the international industrial waterproof grade standard IPX 6.
The plasma chamber has a volume of 560 liters, and the temperature of the plasma chamber is controlled at 50°C; and the flow of nitrogen being fed is 220 sccm.
2. In step (2), the monomer vapour is fed until the vacuum degree is 220 millitorrs, and plasma discharge is started;
the monomer vapour is fed to atomize and volatilize the monomer through a charging pump and introduce the monomer to the reaction chamber at a low pressure of 150 millitorrs, wherein the flow of the monomer vapour fed is 320 µL/min;
the component of the monomer vapour is:
a mixture of three monofunctional unsaturated fluorocarbon resin and one polyfunctional unsaturated hydrocarbon derivative, and the mass percent of the polyfunctional unsaturated hydrocarbon derivative in the monomer vapour is 45%;
the monofunctional unsaturated fluorocarbon resin includes: 3-(perfluoro-5-methylhexyl)-2-hydroxypropyl methacrylate, 1H, 1H,2H,2H-Heptadecafluorodecyl acrylate and 4-ethynyl-trifluorotoluene;
the polyfunctional unsaturated hydrocarbon derivative includes: ethylene glycol diacrylate;
the power of plasma discharge in step (2) is 240 W, the continuous discharge duration is 3200 s, and the plasma discharge is in the manner of microwave discharge.

3. In step (3), a vacuum degree of 160 millitorrs is maintained in the reaction chamber, air is fed after 4 min to make the reaction chamber reach atmospheric pressure.
For underwater electrification resistance, results of underwater soaking test are as follows:
The following table shows a test for time taken when the current of the coating prepared in this embodiment at different voltages reaches 1mA:

| | | | |
|---|---|---|---|
| Voltage | 3.8v | 5v | 12.5v |
| Time | 200min | 90min | 30min |

In IPX 6, under strong water-spray test of 10min, electrical components operate normally.

### Embodiment 5

The process steps of this embodiment are almost the same as those of embodiment 1, and different process parameters are as follows:
1. in step (1), the reaction chamber is vacuumed to a vacuum degree of 200 millitorrs, and inert gas is fed;
the base material is a solid material which is an electrical component, and any interface thereof after the waterproof and electric breakdown-resistant coating is prepared on the surface of the base material may be exposed to the environment of the international industrial waterproof grade standard IPX7.
the plasma chamber has a volume of 780 liters, and the temperature of the plasma chamber is controlled at 55°C; the flow of the inert gas being fed is 250 sccm, and the inert gas is helium.
2. In step (2), the monomer vapour is fed until the vacuum degree is 260 millitorrs, and plasma discharge is started;
the monomer vapour is fed to atomize and volatilize the monomer through a charging pump and introduce the monomer to the reaction chamber at a low pressure of 200 millitorrs, wherein the flow of the monomer vapour fed is 580 µL/min;
the component of the monomer vapour is:
a mixture of four monofunctional unsaturated fluorocarbon resin and two polyfunctional unsaturated hydrocarbon derivative, and the mass percent of the polyfunctional unsaturated hydrocarbon derivative in the monomer vapour is 48%;
the monofunctional unsaturated fluorocarbon resin includes: 2-(perfluorodecyl)ethyl methacrylate,1H,1H,2H,2H-Heptadecafluorodecyl acrylate, 1-Propyne,3,3,3-trifluoro- and 1-ethynyl-3,5-difluorobenzene;
the polyfunctional unsaturated hydrocarbon derivative includes: tripropylene glycol diacrylate and divinylbenzene;
the power of plasma discharge in step (2) is 380 W, the continuous discharge duration is 1600 s, and the plasma discharge is in the manner of medium frequency discharge.

3. In step (3), a vacuum degree of 200 millitorrs is maintained in the reaction chamber, air is fed after 5 min to make the reaction chamber reach atmospheric pressure.
For underwater electrification resistance, results of underwater soaking test are as follows:
The following table shows a test for time taken when the current of the coating prepared in this embodiment at different voltages reaches 1mA:

| | | | |
|---|---|---|---|
| Voltage | 3.8v | 5v | 12.5v |
| Time | >200min | 120min | 40∼45min |

In IPX 7, under water immersion test of 30min (1m underwater), electrical components operate normally.

### Embodiment 6

The process steps of this embodiment are almost the same as those of embodiment 1, and different process parameters are as follows:
1. In step (1), the reaction chamber is vacuumed to a vacuum degree of 200 millitorrs, and inert gas is fed;
the base material is a solid material which is an electrical component, i.e. a sensor, and any interface thereof after the waterproof and electric breakdown-resistant coating is prepared on the surface of the base material may be exposed to the environment of the international industrial waterproof grade standard IPX8.
The plasma chamber has a volume of 1000 liters, and the temperature of the plasma chamber is controlled at 60°C; the flow of the inert gas being fed is 300 sccm, and the inert gas is argon.
2. In step (2), the monomer vapour is fed until the vacuum degree is 300 millitorrs, and plasma discharge is started;
the monomer vapour is fed to atomize and volatilize the monomer through a charging pump and introduce the monomer to the reaction chamber at a low pressure of 200 millitorrs; and the flow of the monomer vapour fed is 1000 µL/min;
the component of the monomer vapour is:
a mixture of five monofunctional unsaturated fluorocarbon resin and three polyfunctional unsaturated hydrocarbon derivative, and the mass percent of the polyfunctional unsaturated hydrocarbon derivative in the monomer vapour is 50%;
the monofunctional unsaturated fluorocarbon resin includes: 3-(perfluoro-5-methylhexyl)-2-hydroxypropyl methacrylate, 1H,1H,2H,2H-Heptadecafluorodecyl acrylate,2-(Perfluorobutyl)ethyl acrylate, 1-Propyne,3,3,3-trifluoro- and 1-ethynyl-3,5-difluorobenzene;
the polyfunctional unsaturated hydrocarbon derivative includes: ethoxylated trimethylolpropane triacrylate, divinylbenzene and neopentyl glycol diacrylate;
the power of plasma discharge in step (2) is 500 W, the continuous discharge duration is 600 s, and the plasma discharge is in the manner of spark discharge.

3. In step (3), a vacuum degree of 200 millitorrs is maintained in the reaction chamber, air is fed after 5 min to make the reaction chamber reach atmospheric pressure.
For underwater electrification resistance, results of underwater soaking test are as follows:
The following table shows a test for time taken when the current of the coating prepared in this embodiment at different voltages reaches 1mA:

| | | | |
|---|---|---|---|
| Voltage | 3.8v | 5v | 12.5v |
| Time | >>200min | >>120min | >100min |

In IPX 8, under diving test of 2h (2m underwater), electrical components operate normally.

## Claims

1. A preparation method of a waterproof and electric breakdown-resistant coating, **characterized in that** the method comprises the following steps:
(1) placing a base material in a plasma reaction chamber, vacuuming the reaction chamber continuously to a vacuum degree of 10-200 millitorrs, and feeding inert gas or nitrogen;
(2) feeding a monomer vapour until the vacuum degree is 30-300 millitorrs, starting plasma discharge to conduct chemical vapor deposition, and preparing a waterproof and electric breakdown-resistant coating on the surface of the base material,
wherein the component of the monomer vapour is:
a mixture of at least one monofunctional unsaturated fluorocarbon resin and at least one polyfunctional unsaturated hydrocarbon derivative, and the mass percent of the polyfunctional unsaturated hydrocarbon derivative in the monomer vapour is 30-50%;
(3) stopping plasma discharge, stopping feeding the monomer vapour, vacuuming continuously to maintain a vacuum degree of 10-200 millitorrs in the reaction chamber, feeding air after 1-5 min to make the reaction chamber reach atmospheric pressure, and then taking out the base material; wherein
the monofunctional unsaturated fluorocarbon resin includes:
3-(perfluoro-5-methylhexyl)-2-hydroxypropyl methacrylate, 2-(perfluorodecyl)ethyl methacrylate, 2-(perfluorohexyl)ethyl methacrylate, 1,1,2,2-Tetrahydroperfluorotetradecyl acrylate, 1H,1H,2H,2H-Heptadecafluorodecyl acrylate, 1H,1H,2H,2H-Perfluorooctylacrylate, 2-(Perfluorobutyl)ethyl acrylate, (2H-perfluoropropyl)-2-acrylate, (perfluorocyclohexyl)methyl acrylate, 1-propyne,3,3,3-trifluoro-, 1-ethynyl-3,5-difluorobenzene or 4-ethynyl-trifluorotoluene; and
the polyfunctional unsaturated hydrocarbon derivative includes:
ethoxylated trimethylolpropane triacrylate, tripropylene glycol diacrylate, divinylbenzene, poly(ethylene glycol) diacrylate, 1,6-hexanediol diacrylate, ethylene glycol diacrylate, diethylene glycol divinyl ether or neopentyl glycol diacrylate.

2. The preparation method of the waterproof and electric breakdown-resistant coating according to claim 1, **characterized in that** the base material in the step (1) is a solid material, and the solid material is an electronic component or an electrical component; and any interface thereof after the waterproof and electric breakdown-resistant coating is prepared on the surface of the base material may be exposed to the environment of the international industrial waterproof grade standards IPX1-IPX8.

3. The preparation method of the waterproof and electric breakdown-resistant coating according to claim 1, **characterized in that** the plasma chamber in the step (1) has a volume of 50-1000 liters, and the temperature of the plasma chamber is controlled at 30-60°C; the flow of the inert gas or nitrogen being fed is 5-300 sccm, and the inert gas is argon or helium or the mixture of both.

4. The preparation method of the waterproof and electric breakdown-resistant coating according to claim 1, **characterized in that** in the step (2):
the monomer vapour is fed to atomize and volatilize the monomer through a charging pump and introduce the monomer into the reaction chamber at a low pressure of 10-200 millitorrs, wherein the flow of the monomer vapour fed is 1000 µL/min.

5. The preparation method of the waterproof and electric breakdown-resistant coating according to claim 1, **characterized in that** in the step (2), before feeding the monomer vapour, the base material is pre-processed by bombardment with glow discharge.

6. The preparation method of the waterproof and electric breakdown-resistant coating according to claim 1, **characterized in that** in the step (2), the power of plasma discharge is 2-500 W, the continuous discharge duration is 600-7200 s, and the plasma discharge is in the manner of radio frequency discharge, microwave discharge, medium frequency discharge or spark discharge.

7. The preparation method of the waterproof and electric breakdown-resistant coating according to claim 6, **characterized in that** the energy output mode controlling the plasma radio frequency during plasma radio frequency discharge is pulse or continuous; when the energy output mode of the plasma radio frequency is by pulse, the pulse duration is 2µs-1ms and the repetition frequency is 20Hz-10kHz.

## Patentansprüche

1. Verfahren zur Herstellung der wasserdichten und elektrisch durchschlagsicheren Beschichtung, **dadurch gekennzeichnet, dass** das Verfahren die folgenden Schritte umfasst:
(1) Einlegen eines Grundmaterials in eine Plasmareaktionskammer, kontinuierliches Vakuumieren der Reaktionskammer bis zu einem Vakuumgrad von 10-200 Millitorr und Zuführen von Inertgas oder Stickstoff;
(2) Zuführen eines Monomerdampfes, bis der Vakuumgrad 30-300 Millitorr beträgt, Starten einer Plasmaentladung zur Durchführung der chemischen Gasphasenabscheidung und Vorbereiten einer wasserdichten und elektrisch durchschlagsicheren Beschichtung auf der Oberfläche des Grundmaterials,
wobei die Komponente des Monomerdampfes:
ein Gemisch aus mindestens einem monofunktionellen ungesättigten Fluorkohlenstoffharz und mindestens einem polyfunktionellen ungesättigten Kohlenwasserstoffderivat ist, und der Massenprozentsatz des polyfunktionellen ungesättigten Kohlenwasserstoffderivats in dem Monomerdampf 30-50% beträgt;
(3) Stoppen der Plasmaentladung, Stoppen der Zufuhr des Monomerdampfes, kontinuierliches Vakumieren, um einen Vakuumgrad von 10-200 Millitorr in der Reaktionskammer aufrechtzuerhalten, Zufuhr von Luft nach 1-5 Minuten, um die Reaktionskammer auf atmosphärischen Druck zu bringen, und dann Herausnehmen des Grundmaterials; wobei
das monofunktionelle ungesättigte Fluorkohlenstoffharz enthält:
3-(Perfluor-5-methylhexyl)-2-hydroxypropylmethacrylat, 2-(Perfluordecyl)ethylmethacrylat, 2-(Perfluorhexyl)ethylmethacrylat, 1,1,2,2-Tetrahydroperfluortetradecylacrylat, 1H,1H,2H,2H-Heptadecafluorodecylacrylat, 1H,1H,2H,2H-Perfluoroctylacrylat, 2-(Perfluorobutyl)ethylacrylat, (2H-Perfluorpropyl)-2-acrylat, (Perfluorcyclohexyl)methylacrylat, 1-Propin,3,3,3-Trifluor-, 1-Ethinyl-3,5-difluorbenzol oder 4-Ethinyltrifluortoluol; und
das polyfunktionelle ungesättigte Kohlenwasserstoffderivat umfasst:
ethoxyliertes Trimethylolpropantriacrylat, Tripropylenglykoldiacrylat, Divinylbenzol, Poly(ethylenglykol)diacrylat, 1,6-Hexandioldiacrylat, Ethylenglykoldiacrylat, Diethylenglykol-Divinylether oder Neopentylglykoldiacrylat.

2. Verfahren zur Herstellung der wasserdichten und elektrisch durchschlagsicheren Beschichtung nach Anspruch 1, **dadurch gekennzeichnet, dass** das Grundmaterial in Schritt (1) ein festes Material ist und das feste Material eine elektronische Komponente oder eine elektrische Komponente ist; und jede Schnittstelle davon, nachdem die wasserdichte und durchschlagsichere Beschichtung auf der Oberfläche des Grundmaterials hergestellt ist, der Umgebung der internationalen industriellen wasserdichten Gradnormen IPX1-IPX8 ausgesetzt werden kann.

3. Verfahren zur Herstellung der wasserdichten und elektrisch durchschlagsicheren Beschichtung nach Anspruch 1, **dadurch gekennzeichnet, dass** die Plasmakammer in Schritt (1) ein Volumen von 50-1000 Litern hat und die Temperatur der Plasmakammer auf 30-60°C geregelt wird; der Durchfluss des zugeführten Inertgases oder Stickstoffs 5-300 sccm beträgt und das Inertgas Argon oder Helium oder eine Mischung aus beiden ist.

4. Verfahren zur Herstellung der wasserdichten und elektrisch durchschlagsicheren Beschichtung nach Anspruch 1, **dadurch gekennzeichnet, dass** in Schritt (2):
der Monomerdampf zugeführt wird, um das Monomer durch eine Ladepumpe zu zerstäuben und zu verflüchtigen und das Monomer in die Reaktionskammer bei einem niedrigen Druck von 10-200 Millitorr einzuführen, wobei der Strom des zugeführten Monomerdampfes 1000 µL/min beträgt.

5. Verfahren zur Herstellung der wasserdichten und elektrisch durchschlagsicheren Beschichtung nach Anspruch 1, **dadurch gekennzeichnet, dass** in Schritt (2), vor der Zuführung des Monomerdampfes das Grundmaterial durch Beschuss mit Glimmentladung vorbehandelt wird.

6. Verfahren zur Herstellung der wasserdichten und elektrisch durchschlagsicheren Beschichtung nach Anspruch 1, **dadurch gekennzeichnet, dass** im Schritt (2) die Leistung der Plasmaentladung 2-500 W beträgt, die Dauer der kontinuierlichen Entladung 600-7200 s beträgt und die Plasmaentladung nach Art einer Hochfrequenzentladung, Mikrowellenentladung, Mittelfrequenzentladung oder Funkenentladung erfolgt.

7. Verfahren zur Herstellung der wasserdichten und elektrisch durchschlagsicheren Beschichtung nach Anspruch 6, **dadurch gekennzeichnet, dass** der Energieausgabemodus, der die Plasma-Hochfrequenz während der Plasma-Hochfrequenzentladung steuert, impulsartig oder kontinuierlich ist; wenn der Energieausgabemodus der Plasma-Hochfrequenz impulsartig ist, beträgt die Impulsdauer 2µs-1ms und die Wiederholungsfrequenz 20Hz-10kHz.

## Revendications

1. Méthode de préparation d'un revêtement imperméable à l'eau et résistant aux pannes électriques, **caractérisée en ce que** la méthode comprend les étapes suivantes :
(1) placer un matériau de base dans une chambre de réaction au plasma, mettre sous vide la chambre de réaction en continu à un degré de vide de 10-200 millitorrs, et alimenter en gaz inerte ou en azote ;
(2) alimenter une vapeur de monomère jusqu'à ce que le degré de vide soit de 30-300 millitorrs, démarrer la décharge de plasma pour procéder au dépôt chimique en phase vapeur, et préparer un revêtement imperméable à l'eau et résistant aux pannes électriques sur la surface du matériau de base,
dans laquelle se trouve le composant de la vapeur de monomère :
un mélange d'au moins une résine fluorocarbonée insaturée monofonctionnelle et d'au moins un dérivé hydrocarboné insaturé polyfonctionnel, et le pourcentage en masse du dérivé d'hydrocarbure insaturé polyfonctionnel dans la vapeur de monomère est de 30-50% ;
(3) arrêter la décharge de plasma, arrêter d'alimenter la vapeur de monomère, mettre sous vide en continu pour maintenir un degré de vide de 10 - 200 millitorrs dans la chambre de réaction, alimenter l'air après 1 - 5 minutes pour que la chambre de réaction atteigne la pression atmosphérique, et puis retirer le matériau de base ; dans laquelle
la résine fluorocarbonée insaturée monofonctionnelle comprend :
Méthacrylate de 3-(perfluoro-5-méthylhexyl)-2-hydroxypropyle, méthacrylate de 2-(perfluorodécyl)éthyle, méthacrylate de 2-(perfluorohexyl)éthyle, acrylate de 1,1,2,2-tétrahydroperfluorotétradécyle, acrylate de 1H,1H,2H,2H-Heptadécafluorodécyle, 1H,1H,2H,2H-Perfluorooctylacrylate, 2-(Perfluorobutyl)éthyl acrylate, (2H-perfluoropropyl)-2-acrylate, (perfluorocyclohexyl)méthyl acrylate, 1-propyne, 3,3,3-trifluoro-, 1-éthynyl-3,5-difluorobenzène ou 4-éthynyl-trifluorotoluène ; et
le dérivé d'hydrocarbure insaturé polyfonctionnel comprend triacrylate de triméthylolpropane éthoxylé, diacrylate de tripropylène glycol, divinylbenzène, poly (éthylène glycol) diacrylate, 1,6-hexanediol diacrylate, éthylène glycol diacrylate, diéthylène glycol divinyl éther ou néopentyl glycol diacrylate.

2. Méthode de préparation du revêtement imperméable à l'eau et résistant aux pannes électriques selon la revendication 1, **caractérisée en ce que** le matériau de base dans l'étape (1) est un matériau solide, et le matériau solide est un composant électronique ou un composant électrique toute interface de celui-ci après la préparation du revêtement imperméable à l'eau et résistant aux pannes électriques sur la surface du matériau de base peut être exposée à l'environnement des normes internationales de qualité industrielle imperméable à l'eau IPX1-IPX8.

3. Méthode de préparation du revêtement imperméable à l'eau et résistant aux pannes électriques selon la revendication 1, **caractérisée en ce que** la chambre à plasma de l'étape (1) a un volume de 50-1000 litres, et la température de la chambre à plasma est contrôlée à 30-60°C ; le débit du gaz inerte ou de l'azote alimenté est de 5 - 300 sccm, et le gaz inerte est de l'argon ou de l'hélium ou un mélange des deux.

4. Méthode de préparation du revêtement imperméable à l'eau et résistant aux pannes électriques selon la revendication 1, **caractérisée en ce que** dans l'étape (2) :
la vapeur de monomère est alimentée pour atomiser et volatiliser le monomère par une pompe de chargement et introduire le monomère dans la chambre de réaction à une basse pression de 10-200 millitorrs, dans laquelle le débit de la vapeur de monomère alimentée est de 1000 µL/min.

5. Méthode de préparation du revêtement imperméable à l'eau et résistant aux pannes électriques selon la revendication 1, **caractérisée en ce que** dans l'étape (2), avant d'alimenter la vapeur de monomère, le matériau de base est prétraité par bombardement à décharge luminescente.

6. Méthode de préparation du revêtement imperméable à l'eau et résistant aux pannes électriques selon la revendication 1, **caractérisée en ce que** dans l'étape (2), la puissance de la décharge de plasma est de 2-500 W, la durée de décharge continue est de 600-7200 s, et la décharge de plasma se fait à la manière d'une décharge de radiofréquence, d'une décharge de micro-ondes, d'une décharge de moyenne fréquence ou d'une décharge à étincelles.

7. Méthode de préparation du revêtement imperméable à l'eau et résistant aux pannes électriques selon la revendication 6, **caractérisée en ce que** le mode de sortie de l'énergie contrôlant la radiofréquence du plasma pendant la décharge de radiofréquence du plasma est impulsionnel ou continu ; lorsque le mode de sortie de l'énergie de la radiofréquence du plasma est par impulsion, la durée de l'impulsion est de 2µs-1ms et la fréquence de répétition est de 20Hz-10kHz.
